# EUROPÄISCHE PATENTSCHRIFT

(11) **EP 2 997 586 B1**
(45) Veröffentlichungstag und Bekanntmachung des Hinweises auf die Patenterteilung: **07.09.2016**
(21) Anmeldenummer: 14725977.4
(22) Anmeldetag: 14.05.2014
(51) Int. Cl.: H01H 3/14, E05F 15/00, F16P 3/12, H03K 17/955

(54) **SCHALTLEISTE, SICHERHEITSSENSORLEISTE UND DEREN HERSTELLUNGSVERFAHREN SOWIE EINKLEMMSCHUTZ**
SWITCH STRIP, SAFETY SENSOR STRIP AND PRODUCTION METHOD THEREOF, AND ALSO ANTI-TRAP PROTECTION
BORD SENSIBLE, RAMPE DE CAPTEURS DE SÉCURITÉ ET PROCÉDÉS POUR LES FABRIQUER, AINSI QUE PROTECTION ANTI-PINCEMENT

(30) Priorität: 14.05.2013 DE 102013104967
(43) Veröffentlichungstag der Anmeldung: 23.03.2016
(73) Patentinhaber: Cooper Standard GmbH, 88131 Lindau (DE)
(72) Erfinder: CLEMENTE, Domenico, 88069 Tettnang (DE); BARRENSCHEEN, Ulf, 88279 Amtzell (DE); SEIDER, Chantal, 88097 Eriskirch (DE)
(74) Vertreter: Flügel Preissner Schober Seidel
(86) Internationale Anmeldenummer: PCT/EP2014/059892
(87) Internationale Veröffentlichungsnummer: WO 2014/184268

(56) Entgegenhaltungen:
- EP-A1- 0 405 351
- DE-A1-102006 015 687
- DE-B3-102005 028 739
- US-A1- 2011 169 513

## Beschreibung

Die Erfindung betrifft eine Schaltleiste, insbesondere eine Schaltleiste für einen Einklemmschutz eines Kraftfahrzeugs.

Eine solche Schaltleiste umfasst eine Innenelektrode, eine Außenelektrode und einen Zwischenraum. Die Außenelektrode umgibt die Innenelektrode mehr oder weniger konzentrisch in einem Abstand. Der Zwischenraum zwischen der Außenelektrode und der Innenelektrode ist isolierend und dielektrisch. Die Außenelektrode ist durch eine von außen angelegte Kraft verformbar. Die Verformung der Außenelektrode ist geeignet, die Innenelektrode und die Außenelektrode wenigstens abschnittsweise miteinander in Kontakt zu bringen.

Eine derartige Schaltleiste kommt bei Verschließelementen von Kraftfahrzeugen, beispielsweise im Bereich einer elektrisch angetriebenen Schiebetür oder bei elektrisch angetriebenen Fenstern und Klappen, wie etwa Kofferraumdeckeln und -türen, sowie Schiebedächern zur Anwendung. Die Schaltleiste ist Teil einer Sicherung gegen ein Einklemmen von Gegenständen oder Körperteilen beim Schließvorgang der Verschließelemente. Die Schaltleiste kann selbstverständlich auch mit anderen elektrisch angetriebenen Verschließelementen, wie etwa Fenstern oder Toren, verwendet werden.

Einklemmschutzsysteme, die derartige Schaltleisten verwenden, werden grundsätzlich in taktile und kapazitive Einklemmschutzsysteme eingeteilt. Bei taktilen Einklemmschutzsystemen ist eine Verformung der Schaltleiste in einem solchen Ausmaß notwendig, dass zwei Elektroden miteinander in Kontakt kommen. Dies setzt eine gewisse Druckkraft auf die Schaltleiste voraus, was im Fall von eingeklemmten Körperteilen von Nachteil sein kann. Ungeachtet dieses Nachteils werden Einklemmschutzsysteme mit Schaltleisten ausgestattet, die auch eine taktile Schaltfunktion ermöglichen, um beispielsweise bei einem Ausfall der kapazitiven Schaltfunktion die Funktion des Einklemmschutzes zu gewährleisten. Auf diese Weise kann auch ein Einklemmen von Gegenständen, wie etwa Holz oder Kunststoff, verhindert werden, die eine nicht erfassbare Kapazitätsänderung der Schaltleiste bewirken.

Demgegenüber bieten kapazitive Einklemmschutzsysteme den Vorteil, dass diese bereits ein Hindernis erkennen, wenn die Kapazität der Schaltleiste verändert wird. Eine Kapazitätsänderung kann zunächst auftreten, wenn sich etwa ein Körperteil der Schaltleiste annähert. Wird aus irgendeinem Grund das Hindernis nicht erkannt, kann eine weitere Kapazitätsänderung durch die Verformung der Schaltleiste auftreten. Sollte auch in diesem Stadium kein Schaltereignis ausgelöst werden, führt spätestens die gegenseitige Berührung der Elektroden zur Erzeugung eines Schaltereignisses. Die Schaltleiste und somit das Einklemmschutzsystem sind zweifach abgesichert.

Eine solche Schaltleiste ist aus der DE 10 2005 028 739 B3 bekannt. Die darin offenbarte Schaltleiste umfasst einen elastisch verformbaren Hohlprofilkörper, der eine Innenfläche aufweist, die einen Hohlraum umrandet. Die Innenfläche weist wenigstens zwei voneinander beabstandete, elektrisch leitfähige Kontaktabschnitte auf. Die Kontaktabschnitte weisen weiter einen oder mehrere Schaltvorsprünge auf.

Aus der DE 10 2008 050 897 A1 ist ein Profil für Sensoren bekannt, das der kapazitiven Erfassung von Hindernissen dient. Das Profil weist zwei parallel zur Längsrichtung des Profils verlaufende und voneinander beabstandete Leiter auf und ist dadurch gekennzeichnet, dass in Erfassungsrichtung von dem ersten Leiter wenigstens ein dritter Leiter innerhalb des Profils beabstandet vorgesehen ist.

Ein Nachteil dieses Profils ist, dass wenigstens eine Richtung existiert, in der das Erfassen von Hindernissen schlechter als in anderen Richtungen funktioniert. Beim Einbau der Schaltleiste muss daher auf die Ausrichtung geachtet werden, was den Einbau erschwert und verteuert.

Ein weiterer Einklemmschutz ist aus der EP 1 154 110 B2 bekannt, der eine kapazitive Schaltleiste umfasst. Ein Hindernis wird dabei direkt mittels eines elektrischen Feldes, das sich in einem Abtastbereich erstreckt, erfasst.

Ein Nachteil dieser Schaltleiste ist, dass gewisse Hindernisse, wie etwa Holz oder Kunststoff, schlecht oder gar nicht erkannt werden.

Weitere taktile Schaltleisten sind aus der US 2004/0107640 A1 und der DE 10 2011 077 014 A1 bekannt. Diese Schaltleisten weisen ebenfalls eine Vorzugsrichtung für eine Verformung auf.

Eine Schaltleiste zum Erkennen eines Hindernisses im Verfahrweg eines Schließelements eines Kraftfahrzeugs offenbart US 2011/169513 A1. Die als verformbarer Streifen ausgebildete Schaltleiste weist einen Sensor auf, der drei elektrische Leitungen umfasst. Die Leitungen sind in einem rohrförmigen Gehäuse angeordnet und erstrecken sich äquidistant entlang der Umfangsrichtung der Innenwand des Gehäuses, um einen zentralen Kern, der elektrisch leitfähig ist. Die Leitungen sind von dem Kern durch einen Hohlraum isoliert. Bei einer äußeren Kraft, die zur Verformung des Gehäuses führt, berührt wenigstens eine der Leitungen den Kern, der durch Abstandshalter zentriert wird.

Eine Sicherheitskontaktschiene, die eine äußere Elektrode und eine innere Elektrode umfasst, beschreibt EP 0 405 351 A1. Zwischen der äußeren Elektrode und der inneren Elektrode ist ein luftgefüllter Zwischenraum angeordnet. Die äußere Elektrode und die innere Elektrode weisen abschnittsweise Kontaktvorsprünge auf. Die äußere Elektrode ist kreisförmig ausgebildet und umgibt die innere Elektrode teilweise. Die innere Elektrode wird durch ein isolierendes, kreisförmiges Elastomerteil von der äußeren Elektrode isoliert.

Ein Profil für Sensoren für die kapazitive Erfassung von Hindernissen, das parallel zur Längsrichtung des Profil verlaufende Leiter aufweist, die voneinander beabstandet sind, offenbart DE 10 2006 015 687 B4.

Der Erfindung liegt daher die Aufgabe zugrunde, eine einfach herstellbare Schaltleiste anzugeben, die unabhängig von einer bestimmten Verdrehung bezüglich der Längsachse funktioniert.

Zur Lösung dieser Aufgabe schlägt die Erfindung eine Schaltleiste mit den Merkmalen des Anspruchs 1 vor. Die erfindungsgemäße Schaltleiste ist für eine Vorrichtung zum Erkennen eines Hindernisses in dem Bewegungsbereich eines Verschließelements, insbesondere eines Kraftfahrzeugs, gedacht. Eine solche Schaltleiste erstreckt sich in eine Längsrichtung, weist eine Kapazität auf. Die Schaltleiste umfasst eine Innenelektrode, die mit einer ersten elektrischen Ladung belegbar ist und eine Außenelektrode, die mit einer zweiten elektrischen Ladung belegbar ist. Die Außenelektrode ist in einem quer zu der Längsrichtung verlaufenden Schnitt annähernd kreisringförmig ausgebildet und umgibt die Innenelektrode in einem Abstand annähernd konzentrisch. Weiter umfasst die Schaltleiste einen mit Luft gefüllten Zwischenraum, der zwischen der Außenelektrode und der Innenelektrode angeordnet und dielektrisch ist. Die Schaltleiste umfasst ferner wenigstens einen quer zu der Längsrichtung verformbaren Abstandhalter, der die Innenelektrode und die Außenelektrode voneinander beabstandet und isoliert. Der Abstandhalter ist im Querschnitt gekrümmt ausgebildet und weist zwei gekrümmte Seitenflächen auf. Die gekrümmten Seitenflächen sind in dieselbe Umfangsrichtung der Schaltleiste gekrümmt. Die Außenelektrode ist durch eine von außen angelegte Kraft verformbar, wobei bei einer Verformung der Außenelektrode die Verformung geeignet sein kann, die Innenelektrode und die Außenelektrode wenigstens abschnittsweise in Kontakt zu bringen.

Da die Schaltleiste entsprechend der vorliegenden Erfindung annähernd radialsymmetrisch aufgebaut ist, gibt es keine Vorzugsrichtung für die Schaltkraft, die einen Schaltvorgang in der Schaltleiste auslöst, sodass die Schaltleiste unabhängig von einer bestimmten Verdrehung bezüglich der Längsachse funktioniert. Der Schaltvorgang, auch Schaltereignis genannt, wird ausgelöst, sobald die beiden Elektroden miteinander in Kontakt sind. Der Begriff "abschnittsweise" kann sich sowohl auf einen Abschnitt der Schaltleiste in axialer Richtung als auch in Umfangsrichtung beziehen.

Gemäß einer weiteren bevorzugten Ausgestaltung findet die Schaltleiste bei einer Vorrichtung zum Erkennen eines Hindernisses in dem Bewegungsbereich eines Verschließelements, insbesondere eines Kraftfahrzeugs, Verwendung. Die Schaltleiste erstreckt sich in eine Längsrichtung und weist eine Kapazität auf. Die Schaltleiste umfasst eine Innenelektrode, die mit einer ersten elektrischen Ladung belegbar ist und eine Außenelektrode, die mit einer zweiten elektrischen Ladung belegbar ist. Die Außenelektrode ist in einem quer zu der Längsrichtung verlaufenden Schnitt annähernd kreisringförmig ausgebildet und umgibt die Innenelektrode in einem Abstand annähernd konzentrisch. Ein Zwischenraum ist zwischen der Außenelektrode und der Innenelektrode angeordnet und dielektrisch. Die Außenelektrode ist durch eine von außen angelegte Kraft verformbar, wobei der Zwischenraum ausgebildet ist, bei der Verformung der Außenelektrode wenigstens abschnittsweise eine Änderung des Abstandes zwischen der Außenelektrode und der Innenelektrode hervorzurufen. Die Änderung des Abstandes ist geeignet, eine erfassbare Änderung der Kapazität der Schaltleiste zu erzeugen.

Aufgrund des annähernd radialsymmetrischen Aufbaus der Schaltleiste entsprechend der vorliegenden Erfindung, gibt es keine Vorzugsrichtung für die Schaltkraft, die einen Schaltvorgang in der Schaltleiste auslöst, sodass die Schaltleiste unabhängig von einer bestimmten Verdrehung bezüglich der Längsachse funktioniert. Die Schaltleiste stellt auch einen Kondensator mit einer bestimmten Kapazität dar. Es ist daher möglich, die Änderung der Kapazität als Schaltereignis festzulegen, für das sich die beiden Elektroden nicht berühren müssen. Ein entsprechendes Hindernis kann einen Schaltvorgang bereits beim Eindringen in die von dem elektrischen Feld durchflutete Umgebung auslösen. Wenn es sich um ein Hindernis handelt, das keine hinreichende Kapazitätsänderung durch Eindringen erzeugen kann, was beispielsweise bei Kunststoff- oder Holzhindernissen der Fall ist, wird das Schaltereignis spätestens beim Berühren der beiden Elektroden ausgelöst. Als zusätzliches Schaltereignis ist es möglich die Kapazitätsänderung bei einer Verformung der Außenelektrode festzulegen, bevor sich die Elektroden berühren.

Der dielektrische Zwischenraum ist mit Luft gefüllt, um eine einfache Verformung der Schaltleiste zu ermöglichen. Der Begriff "dielektrisch" beschreibt in diesem Zusammenhang einen aus einem Stoff oder Stoffgemisch gebildeten, ausschließlich durch ein äußeres Feld polarisierbaren Isolator. Insbesondere fallen also keine Stoffe und Stoffgemische darunter, die durch eine Verformung polarisierbar sind. Daher sind piezoelektrische Stoffe und Stoffgemische, die solche Stoffe enthalten ausgeschlossen.

Die beiden Elektroden der Schaltleiste können grundsätzlich durch Halterungen, die sich außerhalb der Schaltleiste befinden, angeordnet sein. Dabei muss jedoch die Innenelektrode stets gespannt sein, um ein versehentliches Berühren der Außenelektrode zu verhindern. Durch das Hinzufügen eines oder mehrerer Abstandhalter ist es möglich, dass die Schaltleiste in gewissem Ausmaß entlang ihrer Längsachse verbogen werden kann, ohne dass sich die Elektroden berühren. Dadurch kann die Schaltleiste an gekrümmten Bereichen, wie sie etwa an Türen und Fenstern von Kraftfahrzeugen vorkommen, verwendet werden.

Weiter bevorzugt umfasst die Schaltleiste insgesamt wenigstens zwei Abstandhalter. Besonders bevorzugt weist die Schaltleiste insgesamt drei Abstandhalter auf. Bei einer vorteilhaften Ausgestaltung sind die Abstandhalter in Umfangsrichtung der Elektroden äquidistant angeordnet sind.

Vorzugsweise ist der Abstandhalter durch einen annähernd rechteckigen Querschnitt gekennzeichnet.

Weitere Abstandhalter stabilisieren die Innenelektrode zusätzlich gegenüber der Außenelektrode. Die Innenelektrode wird im Fall einer Krümmung der Schaltleiste durch die Abstandhalter im Wesentlichen entlang der neutralen Faser geführt, so dass kein direkter Kontakt zwischen der Innen -und der Außenelektrode auftritt. Die äquidistante Anordnung der Abstandhalter bringt mehr Symmetrie in die Schaltleiste, so dass trotz Abstandhalter auf eine Ausrichtung der Schaltleiste in Umfangsrichtung verzichtet werden kann. Die Anzahl der Abstandhalter kann variieren und der jeweiligen Anwendung angepasst werden. Beispielsweise kann die Zahl der Abstandhalter erhöht werden, wenn die Schaltleiste mit einem kleinen Krümmungsradius beim Einbau verlegt wird, um ein versehentliches Schaltereignis zu verhindern.

Bei einer vorteilhaften Ausgestaltung, weist der Abstandhalter eine Schwächungszone auf. Die Schwächungszone ist bevorzugt als Aussparung in dem Abstandhalter ausgebildet.

Wenn die Abstandhalter der Schaltleiste bereits leicht vorgekrümmt sind, wird weniger Kraft benötigt, um die Außenelektrode der Schaltleiste zu verformen. Die Abstandhalter wirken dabei wie Knickgelenke. Die Knickgelenkte können durch eine Schwächungszone weiter verbessert werden. Durch die gezielte Schwächung des Abstandhalters kann dieser gezielt an der Schwächungszone knicken und die Bewegung ist genauer definiert. Hierdurch wird eine bessere Auslösung eines Schaltereignisses ermöglicht. Die Schwächungszonen sind so gestaltet, dass eine Verwendung der Schaltleiste in gekrümmten Bereichen immer noch möglich ist. Schwächungszonen lassen sich etwa durch gezieltes Aussparen von Material, zum Beispiel am Ansatz oder in der Mitte des Abstandhalters, einfach herstellen. Alternativ können die Schwächungszonen durch einen Elastomerbereich, der eine niedrigere Härte im Vergleich zu dem angrenzenden Elastomerbereich aufweist, gebildet werden.

Weiter bevorzugt umfasst die Schaltleiste wenigstens einen, besonders bevorzugt drei Vorsprünge, die in Umfangsrichtung vorzugsweise äquidistant beabstandet sind. Vorzugsweise weisen die Vorsprünge eine gekrümmte Kontaktfläche auf. Die Vorsprünge sind bevorzugt an der Innenelektrode vorgesehen. Besonders bevorzugt sind die Vorsprünge an der Außenelektrode vorgesehen.

Weiter bevorzugt sind die Vorsprünge und die Abstandhalter in Umfangsrichtung der Schaltleiste abwechselnd angeordnet.

Der Einschränkung der Radialsymmetrie der Schaltleiste durch die Abstandhalter kann durch das Vorsehen von Vorsprüngen wenigstens teilweise kompensiert werden. Zur Verbesserung dieser Kompensation bietet es sich an, die Abstandhalter und die Vorsprünge in Umfangsrichtung abwechselnd anzuordnen. Sind die Vorsprünge an der Außenelektrode vorgesehen, lässt sich die Schaltleiste im Vergleich zu einer Anordnung der Vorsprünge an der Innenelektrode weniger aufwendig extrudieren.

In einer besonders bevorzugten Ausgestaltung ist ein Außendraht in die Außenelektrode eingebettet. Alternativ oder zusätzlich ist ein Innendraht in die Innenelektrode eingebettet. Die Drähte können massiv oder als Litze ausgebildet sein. Es ist auch möglich, dass die Drähte durch ein leitfähiges Elastomer gebildet werden. Die Drähte können beliebig innerhalb der Elektroden angeordnet sein. Der Außendraht kann also beispielsweise entlang des gesamten Umfangs der Außenelektrode angeordnet sein. Der Innendraht kann auch beispielsweise abseits des Zentrums der Innenelektrode angeordnet sein.

Vorzugsweise ist die Außenelektrode wenigstens teilweise aus einem mit elektrisch leitfähigen Partikeln versehenen Elastomer gefertigt. Weiter bevorzugt ist die Innenelektrode wenigstens teilweise aus einem mit elektrisch leitfähigen Partikeln versehenen Elastomer gefertigt. Besonders bevorzugt sind die Außenelektrode und/oder die Innenelektrode extrudiert.

Bei bekannten Schaltleisten sind die Elektroden gewöhnlich aus einem Metall, wie etwa Kupfer, oder einem Kupfergeflecht, gebildet. Um die Herstellung der Schaltleiste entsprechend der vorliegenden Erfindung zu vereinfachen, kann die Innen- oder Außenelektrode oder beide aus einem elektrisch leitfähigen Elastomer gebildet sein. Hierzu wird dem Ethylen-Propylen-Dien-Kautschuk oder dem thermoplastischen Elastomer beispielsweise Graphit zugesetzt. Eine so gebildete Elektrode kann einfach extrudiert werden, ist verformbar und elektrisch leitfähig. Um die Zuverlässigkeit einer solchen Schaltleiste zu verbessern, ist ein Draht, etwa ein Kupferdraht in die aus einem elektrisch leitfähigen Elastomer gebildete Elektrode eingebettet.

In einer weiter bevorzugten Ausgestaltung umfasst die Schaltleiste einen äußeren Mantel, der vorzugsweise an die Außenelektrode angrenzt. Der Mantel umfasst vorzugsweise eine Gleitschicht, die besonders bevorzugt aus Lack, thermoplastischem Vulkanisat und/oder Folie gebildet ist. Der Mantel kann auch von der Gleitschicht gebildet werden, die für diesen Fall bevorzugt isolierend ausgebildet ist.

Solch eine Schaltleiste kann auch verwendet werden, wenn keine Isolierung der Außenelektrode durch eine Halterung der Schaltleiste vorgesehen ist. Die Gleitschicht ermöglicht ein leichtes Einbauen (Einziehen) in Halterungen, die aus Hohlprofilen gebildet sind. Üblicherweise ist die Gleitschicht aus Lack, einem thermoplastischen Vulkanisat und/oder Folie.

Vorzugsweise ist ein Klebesockel vorgesehen. Der Klebesockel ist vorzugsweise auf dem Mantel vorgesehen und dient dem Festkleben der Schaltleiste auf einer Oberfläche. Vorzugsweise umfasst der Klebesockel ein Klebeband, wobei das Klebeband vorzugsweise auf einer Fläche des Klebesockels angeordnet ist, die der Schaltleiste abgewandt ist.

Alternativ ist ein Einknüpfsockel vorgesehen. Der Einknüpfsockel ist bevorzugt auf dem Mantel vorgesehen und ist zum Einknüpfen in eine Öffnung, wie einen Schlitz oder eine Aussparung geeignet.

Alternativ ist ein Klemmsockel vorgesehen. Der Klemmsockel ist bevorzugt auf dem Mantel vorgesehen und ist zum Aufstecken auf beispielsweise Flansche geeignet. Der Klemmsockel kann dabei auch durch eine verstärkende Einlage in seiner Haltefunktion verstärkt werden.

Durch den Klebe- oder Einknüpfsockel beziehungsweise den Klemmsockel kann die Schaltleiste ganz ohne ein Trägerprofil montiert werden.

Weiter bevorzugt ist der Mantel und/oder der Abstandhalter und/oder der Klebesockel und/oder der Einknüpfsockel aus einem Elastomer, vorzugsweise einem Ethylen-Propylen-Dien-Kautschuk (EPDM) oder einem thermoplastische Elastomer (TPE), gefertigt. Bevorzugt sind der Mantel und/oder der Abstandhalter und/oder der Klebesockel und/oder der Einknüpfsockel und/oder der Klemmsockel extrudiert.

Diese Ausgestaltung der Schaltleiste ist einfacher herstellbar, da sie in einem Arbeitsgang extrudiert werden kann.

Die Erfindung betrifft außerdem eine Schaltleiste für eine Vorrichtung zum Erkennen eines Hindernisses in dem Bewegungsbereich eines Verschließelements, insbesondere eines Kraftfahrzeugs. Die Schaltleiste erstreckt sich in eine Längsrichtung und weist ein Zentrum und eine Kapazität auf. Die Schaltleiste umfasst eine Grundelektrode, die eine konkave innere Kontaktfläche aufweist und die mit einer ersten elektrischen Ladung belegbar ist. Die Schaltleiste umfasst weiter eine Sensorelektrode, die eine konvexe innere Kontaktfläche aufweist und die mit einer zweiten elektrischen Ladung belegbar ist und die der Grundelektrode gegenüberliegt. Die Schaltleiste umfasst einen Mantel, der die beiden Elektroden voneinander isoliert, der verformbar ist. Der Mantel weist einen Sensorabschnitt und einen Grundabschnitt auf. Weiter umfasst die Schaltleiste einen Zwischenraum, der zwischen der Grundelektrode und der Sensorelektrode angeordnet und dielektrisch ist. Die Grundelektrode ist in dem Grundabschnitt angeordnet und die Sensorelektrode ist in dem Sensorabschnitt angeordnet ist. Die inneren Kontaktflächen sind einander zugewandt. Die Grundelektrode und die Sensorelektrode sind relativ zueinander bewegbar.

Es ist bevorzugt, dass die inneren Kontaktflächen einander direkt gegenüberliegen. Weiter bevorzugt umfasst die Grundelektrode eine erste konvexe äußere Kontaktfläche die der Sensorelektrode abgewandt angeordnet ist. Weiter bevorzugt umfasst die Sensorelektrode eine zweite konvexe äußere Kontaktfläche die der Grundelektrode abgewandt angeordnet ist.

Vorzugsweise ist der Sensorabschnitt elektrisch leitfähig ausgebildet. Vorzugsweise umfasst die Schaltleiste einen bevorzugt in die Grundelektrode eingebetteten Grunddraht. Weiter vorzugsweise umfasst die Schaltleiste einen bevorzugt in die Sensorelektrode eingebetteten Sensordraht.

Weiter bevorzugt weist die Grundelektrode zwei Vorsprünge auf, die vorzugsweise geeignet sind, die konkave innere Kontaktfläche zu umschließen. Bevorzugt sind die Vorsprünge konvex gekrümmt und haben vorzugsweise annähernd identische Krümmungsradien. Ferner bevorzugt ist der Krümmungsradius der konkaven inneren Kontaktfläche größer als die Krümmungsradien der Vorsprünge.

Es ist bevorzugt, dass die Schaltleiste eine Gleitschicht, insbesondere aus TPV, Lack und/oder Folie aufweist, die bevorzugt entlang des gesamten Umfangs der Schaltleiste aufgebracht ist.

Die Erfindung betrifft zudem eine Sicherheitssensorleiste, die ein Trägerprofil umfasst, das einen Befestigungsabschnitt und einen Aufnahmeabschnitt aufweist.

Weiter umfasst die Sicherheitssensorleiste eine Ausführungsform der erfindungsgemäßen Schaltleiste, die in dem Aufnahmeabschnitt angeordnet ist.

Die Schaltleiste entsprechend der vorliegenden Erfindung wird im Allgemeinen nicht alleine, sondern in Kombination mit einem Trägerprofil verwendet. Ein solches Trägerprofil kann beispielsweise ein Dichtungsprofil sein. Die Kombination aus Schaltleiste und Trägerprofil wird Sicherheitssensorleiste oder auch kurz Sensorleiste genannt.

Bevorzugt umfasst der Aufnahmeabschnitt einen Hohlraum und die Schaltleiste ist in dem Hohlraum angeordnet. Besonders bevorzugt weist der Hohlraum eine Gleitschicht auf, die insbesondere aus Lack, thermoplastischem Vulkanisat und/oder Folie gebildet ist.

Die Sicherheitssensorleiste mit Gleitschicht erlaubt, dass verschiedene Ausführungsformen der Schaltleiste oder bekannte Schaltleisten einfach in einen Hohlraum des Trägerprofils eingezogen werden können. Das Einziehen der Schaltleiste kann mittels Druckluftunterstützung weiter vereinfacht werden.

Vorzugsweise ist der Befestigungsabschnitt ausgebildet, an einem Vorsprung eines Kraftfahrzeugs befestigt zu werden. Vorzugsweise umfasst der Befestigungsabschnitt eine Klebstoffschicht. Weiter bevorzugt umfasst der Befestigungsabschnitt eine Dichtmasse.

Eine solche Sensorleiste kommt beispielsweise bei Fahrzeugen mit elektrischen Fensterhebern oder elektrisch bewegbaren Türen oder Klappen zum Einsatz. Die Sensorleiste kann dabei entweder auf eine vorhandene Montagefläche geklebt werden oder auf einen Vorsprung oder Flansch des Kraftfahrzeugs gesteckt oder mit entsprechenden Ausformungen in Aussparungen gesteckt werden. Die Dichtmasse in dem Befestigungsabschnitt verhindert ein Eindringen von Feuchtigkeit und/oder Fremdkörpern, sodass der Vorsprung oder Flansch besser geschützt ist. Zusätzlich hat das Trägerprofil eine erhöhte Dichtwirkung.

Die Erfindung betrifft weiter eine Vorrichtung zum Erkennen eines Hindernisses in dem Bewegungsbereich eines Verschließelements, insbesondere eines Kraftfahrzeugs. Eine solche Vorrichtung umfasst wenigstens eine Sicherheitssensorleiste entsprechend einer Ausführungsform der vorliegenden Erfindung. Weiter umfasst die Vorrichtung eine Steuereinheit, die einen Öffnungs- oder Schließvorgang des Verschließelements in Abhängigkeit von der Sicherheitssensorleiste steuert.

Es ist bevorzugt, dass die Steuereinheit eine Bewegung des Verschließelements in Abhängigkeit von der Sicherheitssensorleiste unterbricht. Alternativ oder zusätzlich ist bevorzugt, dass die Steuereinheit die Bewegung des Verschließelements in Abhängigkeit von der Sicherheitssensorleiste reversiert.

Die Sensorleiste bildet zusammen mit einer Steuereinheit eine Vorrichtung zum Erkennen eines Hindernisses. Eine solche Vorrichtung, auch Einklemmschutz genannt, steuert die Bewegung eines Verschließelements, wie etwa eines Fensters oder einer Kraftfahrzeugtür, in Abhängigkeit von der Sensorleiste.

Bevorzugt legt die Steuereinheit die erste elektrische Ladung und die zweite elektrische Ladung so an die Sicherheitssensorleiste, dass ein elektrisches Feld erzeugbar ist. Das elektrische Feld durchflutet die Umgebung der Sicherheitssensorleiste. Die Steuereinheit ist weiter bevorzugt so ausgebildet, dass sie ein Eindringen des Hindernisses in die durchflutete Umgebung aufgrund einer Änderung der Kapazität erkennen kann.

Ein derartig ausgestalteter Einklemmschutz ist zweifach abgesichert. Dringt ein Hindernis in die durchflutete Umgebung der Sicherheitssensorleiste ein und verändert dadurch die Kapazität, erfasst die Steuereinheit dies als Schaltereignis und steuert das Verschließelement entsprechend. Kann das Hindernis die Kapazität nicht hinreichend ändern, erfasst die Steuereinheit die Kapazitätsänderung der Schaltleiste aufgrund der Verformung der Außenelektrode. Die Außenelektrode und Innenelektrode sind dabei noch nicht in Kontakt. Sollte auch diese Kapazitätsänderung nicht von der Steuereinheit registriert werden, ist als letzte Stufe der direkte Kontakt der Elektroden als Schaltereignis definiert, das in jedem Fall erfassbar ist.

Die Erfindung betrifft außerdem ein Verfahren zur Herstellung einer Sicherheitssensorleiste entsprechend der vorliegenden Erfindung. Hierzu werden ein an sich bekanntes Trägerprofil, das einen Aufnahmeabschnitt, insbesondere mit einem Hohlraum, und einen Befestigungsabschnitt aufweist, und eine Schaltleiste entsprechend der vorliegenden Erfindung bereitgestellt. Die Schaltleiste wird in den Hohlraum, eingezogen.

Es ist bevorzugt, dass die Schaltleiste und/oder der Aufnahmeabschnitt, insbesondere der Hohlraum, mit einer Gleitschicht, insbesondere aus Lack, thermoplastischem Vulkanisat und/oder Folie versehen wird/werden. Vorzugsweise wird der Befestigungsabschnitt mit einer Klebstoffschicht versehen, insbesondere nachdem die Schaltleiste eingezogen worden ist.

Erfindungsgemäß wird die Schaltleiste unter Drehen eingezogen. Alternativ oder zusätzlich wird das Grenzvolumen zwischen der Außenfläche der Schaltleiste und der Innenfläche des Aufnahmeabschnitts beim Einziehen mit Druckluft beaufschlagt.

Gewöhnlich werden die Schaltleiste und das Trägerprofil getrennt voneinander hergestellt und erst dann zusammengefügt. Das Trägerprofil ist dabei meist ein Dichtungsprofil. Je nach Ausbildung des Aufnahmeabschnitts wird die Schaltleiste einfach in den Aufnahmeabschnitt gedrückt oder im Fall, dass der Aufnahmeabschnitt einen Hohlraum umfasst, in diesen eingezogen. Das Verringern der Reibung zwischen der Schaltleiste und dem Aufnahmeabschnitt und/oder dem Hohlraum durch die Gleitschicht und/oder das Beaufschlagen mit Druckluft erleichtert das Einziehen. Ein zufälliges Verdrehen der Schaltleiste entlang ihrer Längsrichtung ist aufgrund der hohen Symmetrie weniger relevant und muss nicht korrigiert werden, um eine zuverlässige Schaltfunktion zu ermöglichen. Die Zuverlässigkeit der Sicherheitssensorleiste kann durch ein kontrolliertes Drehen der Schaltleiste beim Einziehen weiter gesteigert werden. Eine solche Sicherheitssensorleiste lässt sich zusätzlich einfacher und kostengünstiger herstellen.

Ausführungsbeispiele der vorliegenden Erfindung werden unter Bezug auf die anhängenden Zeichnungen beschrieben. Darin zeigt:
- Fig. 1: eine Skizze eines Kraftfahrzeugs mit einem Einklemmschutz;
- Fig. 2: eine seitliche Teilansicht einer elektrisch bewegbaren Kraftfahrzeugtür mit einer Sicherheitssensorleiste;
- Fig. 3: eine Draufsicht auf die Kraftfahrzeugtür aus Fig. 2;

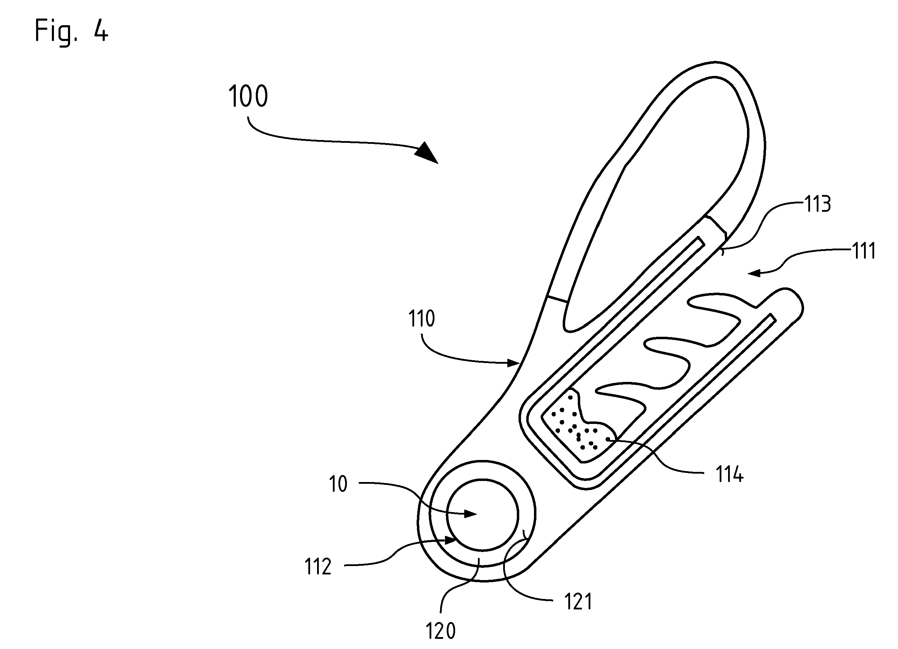

- Fig. 4: ein Querschnitt eines Ausführungsbeispiels der Sicherheitssensorleiste;
- Fig. 5: ein Querschnitt eines ersten nicht der Erfindung entsprechenden Ausführungsbeispiels der Schaltleiste;
- Fig. 6: ein Querschnitt eines zweiten Ausführungsbeispiels der Schaltleiste;
- Fig. 7: ein Querschnitt eines dritten nicht der Erfindung entsprechenden Ausführungsbeispiels der Schaltleiste;
- Fig. 8: ein Querschnitt eines vierten Ausführungsbeispiels der Schaltleiste;
- Fig. 9: ein Querschnitt eines fünften Ausführungsbeispiels der Schaltleiste;
- Fig. 10: ein Querschnitt eines sechsten nicht der Erfindung entsprechenden Ausführungsbeispiels der Schaltleiste;
- Fig. 11: ein Querschnitt eines siebten Ausführungsbeispiels der Schaltleiste;
- Fig. 12: ein Querschnitt eines achten Ausführungsbeispiels der Schaltleiste;
- Fig. 13: eine Tabelle zur Übersicht der möglichen Biegeradien der vorgenannten Ausführungsbeispiele;

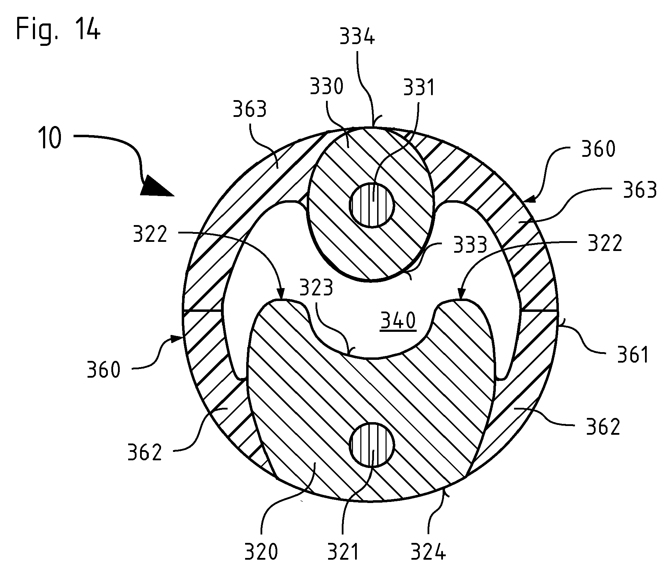

- Fig. 14: ein Querschnitt eines neunten Ausführungsbeispiels der Schaltleiste, und

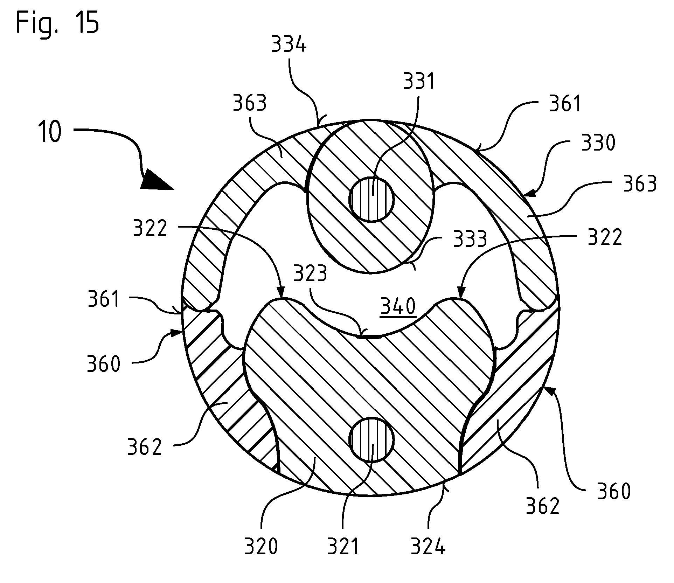

- Fig. 15: ein Querschnitt eines zehnten Ausführungsbeispiels der Schaltleiste.

Das erste Ausführungsbeispiel einer Schaltleiste 10 umfasst eine Innenelektrode 20, eine Außenelektrode 30, einen Zwischenraum 40, drei Abstandhalter 50 und einen Mantel 60. Die Schaltleiste 10 weist eine Kapazität auf und erstreckt sich in eine Längsrichtung senkrecht zu der Zeichenebene.

Die Innenelektrode 20 ist aus einem mit einem leitfähigen Zusatz, wie etwa Graphit, versehenen Ethylen-Propylen-Dien-Kautschuk (EPDM) gebildet. In die Innenelektrode 20 ist ein Innendraht 21 aus leitfähigem Material, wie etwa Kupfer, eingebettet. Die Außenelektrode 30 ist wie die Innenelektrode 20 aus einem mit einem leitfähigem Zusatz, wie Graphit, versehenem EPDM gebildet und hat einen eingebetteten Außendraht 31, der ebenfalls aus einem leitfähigen Material, wie etwa Kupfer, gefertigt ist. Der Zwischenraum 40, der sich zwischen der Innenelektrode 20 und der Außenelektrode 30 befindet, ist mit Luft gefüllt. Die Abstandhalter 50 sind aus einem thermoplastischen Elastomer (TPE) oder EPDM gebildet und elektrisch isolierend. Der Mantel 60 ist mit einer Gleitschicht 61 aus Lack versehen.

Die Außenelektrode 30 umgibt die Innenelektrode 20 annähernd konzentrisch. Es ist nicht notwendig, dass sich die Innenelektrode 20 exakt in der Mitte der Außenelektrode 30 befindet. Je nach Krümmung der Schaltleiste 10 ist es möglich, dass die Innenelektrode 20 auf einer Seite der Außenelektrode 30 näher als auf einer anderen Seite ist. Die Abstandhalter 50, die in Umfangsrichtung äquidistant angeordnet sind, beabstanden und isolieren die beiden Elektroden 20, 30 voneinander, so dass dennoch kein direkter Kontakt zwischen den beiden Elektroden 20, 30 entsteht. Wenn die Schaltleiste 10 verkrümmt wird, positionieren die Abstandhalter 50 die Innenelektrode 20 im Wesentlichen entlang der neutralen Faser der Krümmung. Die Innenelektrode 20 und die Außenelektrode 30 befinden sich dann in Radialrichtung in einem Abstand D voneinander.

Wirkt nun eine Kraft F von außen auf die Schaltleiste 10, wird zunächst der Mantel 60 und unmittelbar danach die Außenelektrode 30 verformt. Dabei ändert sich der Abstand D zwischen den beiden Elektroden 20, 30 abschnittsweise. Da die Schaltleiste 10 einen im Wesentlichen zylinderförmigen Kondensator bildet, ändert sich die Kapazität der Schaltleiste 10, wenn sich der Abstand D zwischen den Elektroden 20, 30 verändert. Diese Änderung der Kapazität kann von einer geeigneten elektronischen Schaltung, wie einer weiter unten beschriebenen Steuereinheit, erfasst werden und ein Schaltereignis darstellen.

Ist die Kraft F groß genug, wird sich die Schaltleiste 10 beziehungsweise die Außenelektrode 30 und der Mantel 60 so weit verformen, dass die beiden Elektroden 20, 30 miteinander in Kontakt kommen. Dieser Kurzschluss kann ebenfalls ein Schaltereignis darstellen.

Das zweite Ausführungsbeispiel einer Schaltleiste 10 ist ähnlich zu dem ersten Ausführungsbeispiel und wird daher nur in seinen Unterschieden beschrieben.

Die Schaltleiste 10 gemäß dem zweiten Ausführungsbeispiel hat drei Abstandhalter 50, die jeweils zwei gekrümmte Seitenflächen 51 aufweisen. Die Abstandhalter 50 haben daher die Form eines Kreisbogens. Wirkt nun eine Kraft F von außen auf die Schaltleiste 10, erlauben die Abstandhalter 50 eine einfachere Verformung der Schaltleiste 10, da sie leichter knickbar sind. Dabei bewegt sich ein erstes Ende eines Abstandhalters 50, das an der Außenelektrode 30 angeordnet ist, in Richtung eines zweiten Endes des Abstandhalters 50, das an der Innenelektrode 20 angeordnet ist. Die gekrümmten Seitenflächen 51 werden dabei noch weiter verkrümmt und in eine Umfangsrichtung der Schaltleiste 10 bewegt. Der Abstandhalter 50 verhält sich in diesem Fall ähnlich wie ein Knickgelenk.

Eine Schaltleiste 10 entsprechend einem dritten Ausführungsbeispiel ist ähnlich einer Schaltleiste gemäß dem ersten Ausführungsbeispiel und wird daher nur in ihren Unterschieden beschrieben.

Die Schaltleiste 10 umfasst im Vergleich zum ersten Ausführungsbeispiel eine Innenelektrode 20, die drei Vorsprünge 22 aufweist. Die Vorsprünge 22 sind mit Abstandhaltern 50 in Umfangsrichtung abwechselnd angeordnet. Wirkt von außen eine Kraft F auf die Schaltleiste 10, so kommt die Außenelektrode 30 wesentlich früher in Kontakt mit der Innenelektrode 20. Um ein Schaltereignis auszulösen wird daher eine geringere Kraft F benötigt. Ein Hindernis kann somit wesentlich früher und sicherer erkannt werden.

Eine Schaltleiste 10 entsprechend dem vierten Ausführungsbeispiel kombiniert sämtliche Vorteile der anderen Ausführungsbeispiele. Die Schaltleiste 10 umfasst daher sowohl die gekrümmten Abstandhalter 50 als auch die Vorsprünge 22. Diese Schaltleiste 10 ist sehr leicht durch eine äußere Kraft F verformbar und kann ein Schaltereignis sowohl kapazitiv als auch taktil erfassen.

Eine Schaltleiste 10 entsprechend einem fünften Ausführungsbeispiel hat einen Aufbau entsprechend dem dritten Ausführungsbeispiel. Zusätzlich umfasst dieses Ausführungsbeispiel einen Klebesockel 62, der auf dem Mantel 60 angeordnet ist. Der Klebesockel 62 ist mit dem Mantel 60 koextrudierbar. Weiter umfasst der Klebesockel 62 ein Klebeband 63, das auf einer Fläche des Klebesockels 62 angebracht ist, die der Schaltleiste 10 abgewandt ist. Die Schaltleiste 10 kann so auf eine Fläche geklebt werden ohne ein Trägerprofil zu verwenden. Es ist selbstverständlich auch möglich den Klebesockel 62 bei den anderen Ausführungsbeispielen zu verwenden.

Eine Schaltleiste 10 entsprechend einem sechsten Ausführungsbeispiel hat einen Aufbau entsprechend dem ersten Ausführungsbeispiel. Zusätzlich umfasst dieses Ausführungsbeispiel einen Einknüpfsockel 64, der auf dem Mantel 60 angeordnet ist. Der Einknüpfsockel 64 ist mit dem Mantel 60 koextrudierbar. Die Schaltleiste 10 kann mit dem Einknüpfsockel 64 in Aussparungen und dergleichen eingefügt werden ohne ein Trägerprofil zu verwenden. Es ist selbstverständlich auch möglich den Einknüpfsockel 64 bei den anderen Ausführungsbeispielen zu verwenden.

Eine Schaltleiste 10 entsprechend einem siebten Ausführungsbeispiel hat einen Aufbau entsprechend dem vierten Ausführungsbeispiel. Zusätzlich umfasst dieses Ausführungsbeispiel einen Klemmsockel 65, der auf dem Mantel 60 angeordnet ist. Der Klemmsockel 65 ist mit dem Mandel koextrudierbar. Der Klemmsockel 65 ist so gefertigt, dass er auf einen Flansch gesteckt werden kann. In dem Klemmsockel 65 angeordnete Klemmlippen 66 verrasten die Schaltleiste mit dem Flansch. Es ist selbstverständlich auch möglich den Klemmsockel 65 bei den anderen Ausführungsbeispielen zu verwenden.

Eine Schaltleiste 10 in Übereinstimmung mit einem achten Ausführungsbeispiel ist ähnlich zu dem vierten Ausführungsbeispiel. Im Unterschied zu diesem umfasst statt der Innenelektrode 20 die Außenelektrode 30 drei Vorsprünge 32. Die Vorsprünge 32 sind als von der Innenelektrode 20 aus betrachtet konkav gekrümmte Erhebungen ausgebildet. Drei, vorzugsweise äquidistant angeordnete, Abstandhalter 50 sind im Querschnitt gekrümmt ausgebildet. Die Abstandhalter 50 weisen zudem Schwächungszonen 52 auf, die ein leichteres knicken ermöglichen. Die Schwächungszonen 52 sind beispielsweise durch Aussparungen 53 in dem Abstandhalter 50 gebildet. Wenngleich die Schwächungszonen 52 lediglich in diesem Ausführungsbeispiel beschrieben wurden, sind diese jedoch auch auf andere Ausführungsbeispiele der Erfindung anwendbar.

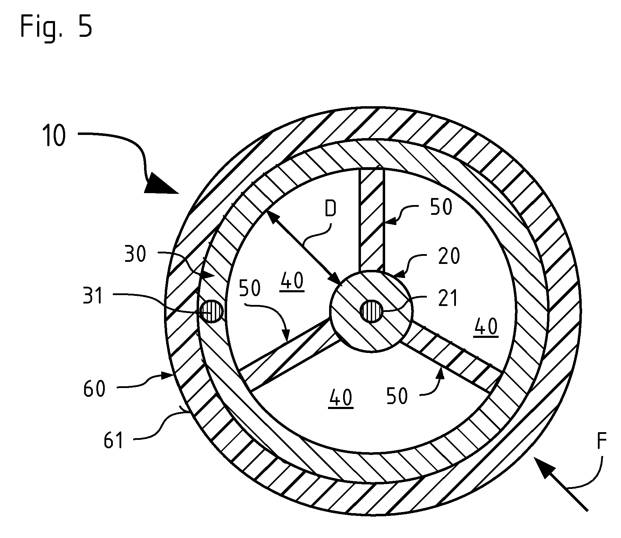

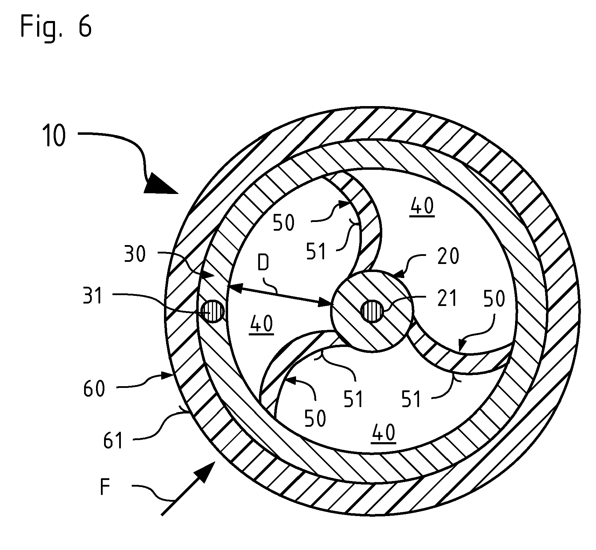

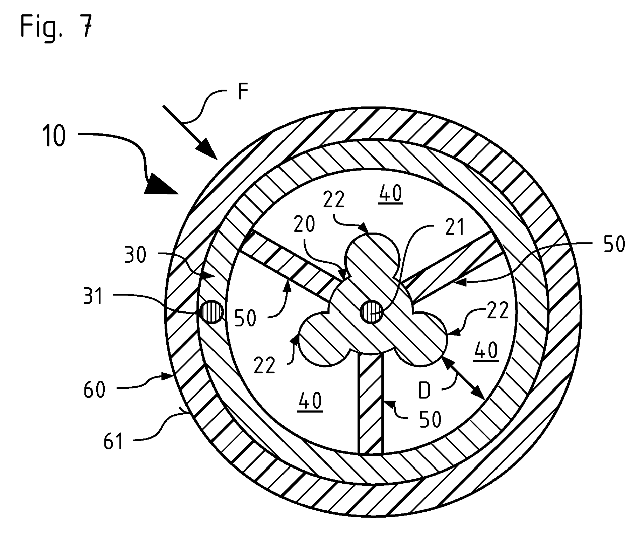

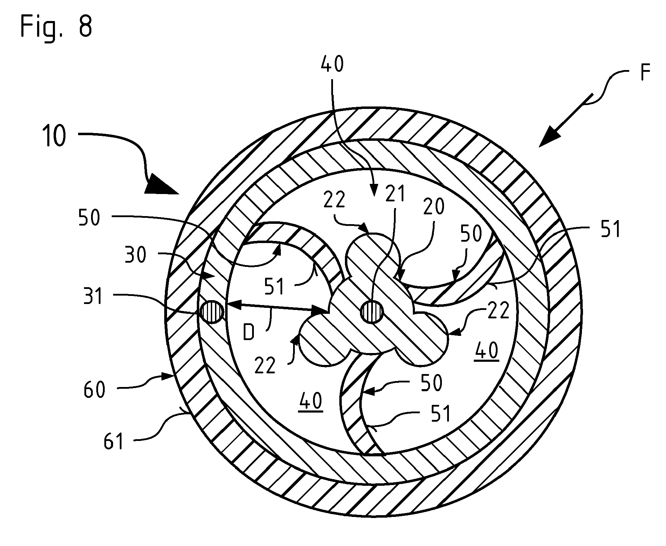

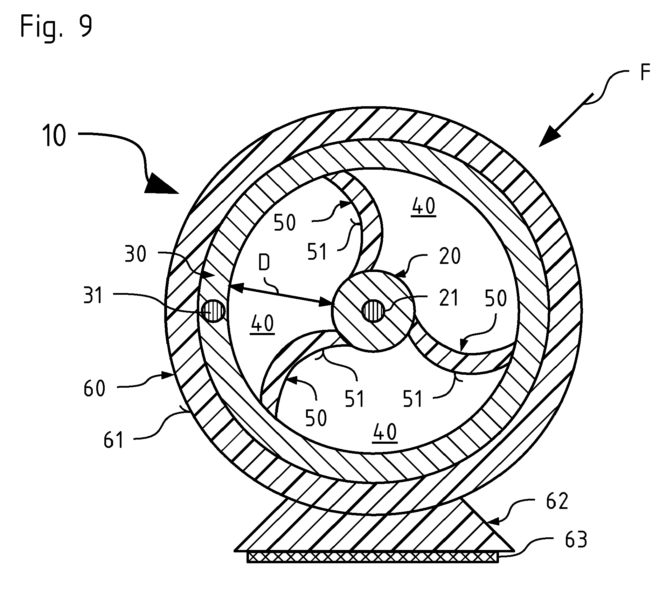

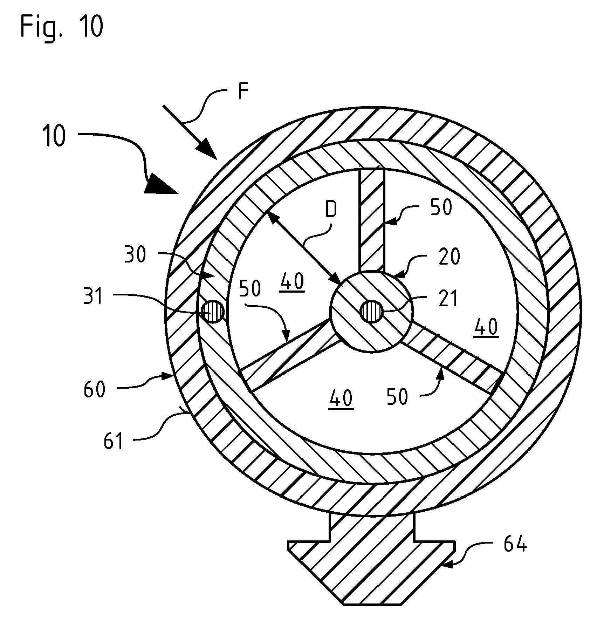

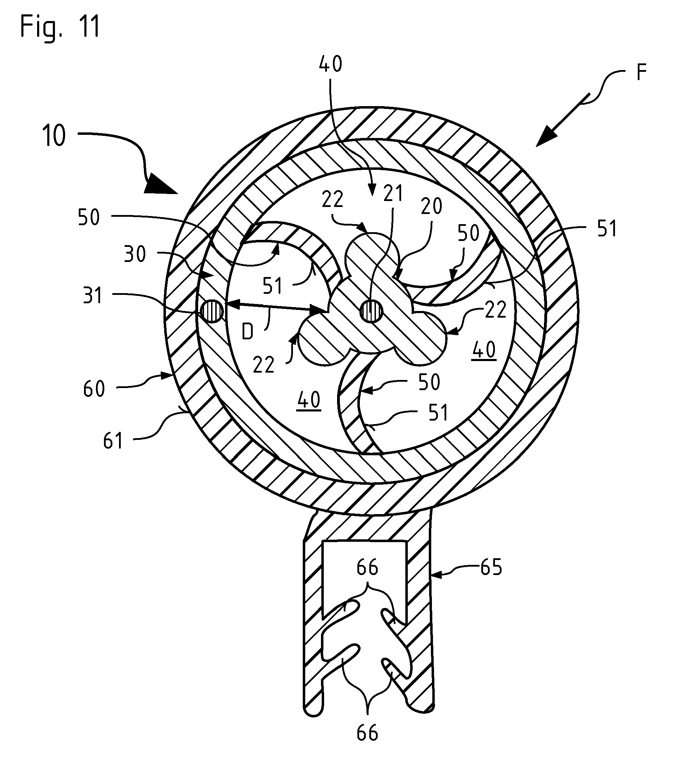

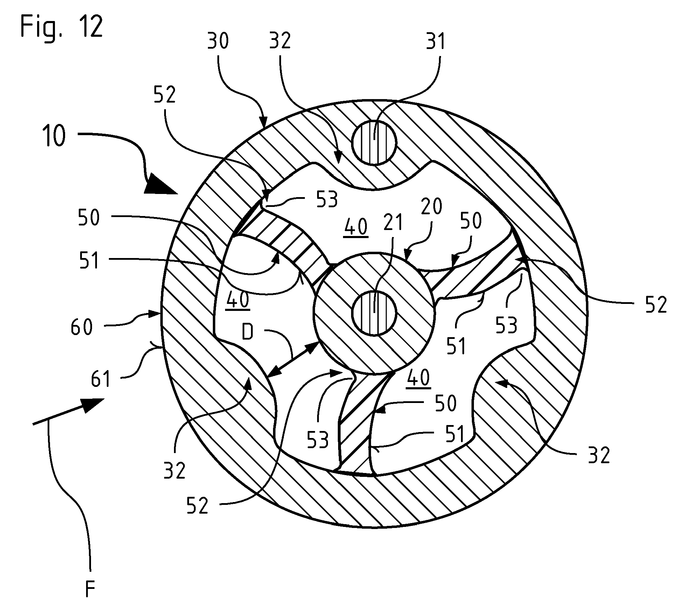

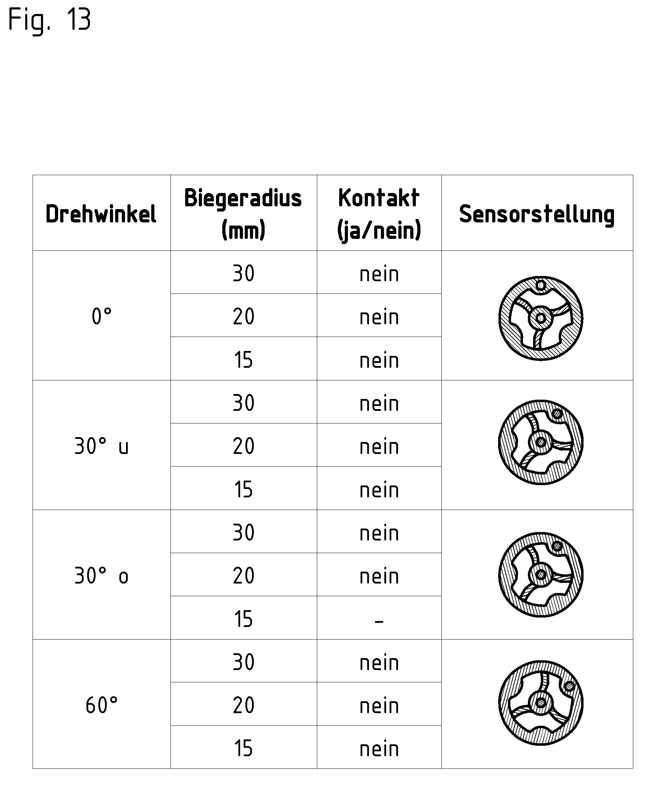

Wie in den Fig. 5 bis 12 durch die Kraftpfeile angedeutet, spielt die Richtung der von außen wirkenden Kraft F für die Schaltleiste 10, wie in der Tabelle in Fig. 13 dargestellt, eine untergeordnete Rolle. Der Drehwinkel ist in Umfangsrichtung der Schaltleiste 10 gemessen. Bei dem mit "o" bezeichneten Drehwinkel oder bei Drehwinkeln ohne Angabe wurde die Schaltleiste 10 entlang der Längsrichtung betrachtet nach oben gebogen. Bei dem mit "u" bezeichnete Drehwinkel wurde die Schaltleiste 10 in Längsrichtung nach unten gebogen. Der Biegeradius wird von dem Biegezentrum der Schaltleiste 10 bis zu deren Außenoberfläche, beispielsweise der Gleitschicht 61, gemessen. In der Spalte "Kontakt" ist angegeben, ob die Elektroden 20, 30 der Schaltleiste 10 im Biegezustand einander berühren. Die Spalte "Sensorstellung" zeigt schematisch die Ausrichtung der Schaltleiste. In den berechneten Fällen, ruft eine Biegung der Schaltleiste 10 entlang der Längsachse eine Verformung der Außenelektrode 20 hervor, so dass die Elektroden 20, 30 miteinander in Kontakt geraten. Erst wenn die Kraft F von außen auf die Außenelektrode 20 wirkt, können die Elektroden 20, 30 einander berühren. Auch die spezifische Wahl des Abstandes D ist weniger relevant, da nur Veränderungen der Kapazität oder ein direkter Kurzschluss der beiden Elektroden 20, 30 ein Schaltereignis darstellen.

Das neunte Ausführungsbeispiel einer Schaltleiste 310 umfasst eine Grundelektrode 320, eine Sensorelektrode 330, einen Zwischenraum 340 und einen Mantel 360. Die Schaltleiste 310 weist ein Zentrum und eine Kapazität auf und erstreckt sich in eine Längsrichtung senkrecht zu der Zeichenebene. Der Mantel 360 weist einen Grundabschnitt 362 und einen Sensorabschnitt 363 auf. Der Mantel 360 ist aus EPDM gebildet, elastisch verformbar und isolierend. Der Grundabschnitt 362 und der Sensorabschnitt 363 sind im Wesentlichen halbkreisförmig ausgebildet.

Die Grundelektrode 320 ist in dem Grundabschnitt 362 angeordnet. Die Grundelektrode 320 ist aus mit einem leitfähigen Zusatz, wie etwa Graphit, versehenen EPDM gebildet. In die Grundelektrode 320 ist ein Grunddraht 321 aus leitfähigem Material, wie etwa Kupfer, eingebettet. Die Grundelektrode 320 weist eine erste innere Kontaktfläche 323 auf, die dem Zentrum zugewandt ist, und weist eine erste äußere Kontaktfläche 324 auf, die dem Zentrum abgewandt ist. Die innere Kontaktfläche 323 ist konkav gekrümmt. Die Grundelektrode 322 weist weiter zwei Vorsprünge 322 auf, die benachbart zu der ersten inneren Kontaktfläche 323 angeordnet sind. Die Vorsprünge 322 weisen eine konvexe Krümmung auf. Die Krümmungsradien der Vorsprünge 322 sind jeweils kleiner als der Krümmungsradius der inneren Kontaktfläche 323. Insbesondere haben die beiden Vorsprünge 322 identische Krümmungsradien. Die Vorsprünge 322 und die innere Kontaktfläche 323 sind an die Sensorelektrode 330 angepasst, so dass die Vorsprünge 322 und die innere Kontaktfläche 323 die Sensorelektrode 330 vollständig umgreifen können, auch dann, wenn sich die Grundelektrode 320 noch nicht verformt hat.

Die Sensorelektrode 330 ist in dem Sensorabschnitt 363 angeordnet. Die Sensorelektrode 330 ist wie die Grundelektrode 320 aus einem mit einem leitfähigem Zusatz, wie Graphit, versehenem EPDM gebildet und hat einen eingebetteten Sensordraht 331, der ebenfalls aus einem leitfähigen Material, wie etwa Kupfer, gefertigt ist. Die Sensorelektrode 320 weist eine zweite innere Kontaktfläche 333 auf, die dem Zentrum zugewandt ist, und weist eine zweite äußere Kontaktfläche 334 auf, die dem Zentrum abgewandt ist. Die zweite innere Kontaktfläche 333 ist derart konvex gekrümmt, dass die innere Kontaktfläche 323 vollflächig daran anliegen kann, ohne verformt werden zu müssen.

Der Zwischenraum 340, der sich zwischen der Grundelektrode 320 und der Sensorelektrode 330 befindet, ist mit Luft gefüllt. Die Schaltleiste 310 ist mit einer Gleitschicht 361 aus isolierendem Lack versehen, welche die äußeren Kontaktflächen 324, 334 von der Umgebung isoliert. Die gesamte Schaltleiste 310 ist in einem Arbeitsgang einstückig extrudiert, kann aber selbstverständlich auch anders hergestellt sein.

Wirkt nun eine Kraft F von außen auf die Schaltleiste 310, wird zunächst der Mantel 360 verformt und dadurch die Sensorelektrode 330 bewegt. Dabei ändert sich der Abstand D zwischen den beiden Elektroden 320, 330. Da die Schaltleiste 310 einen Kondensator bildet, ändert sich die Kapazität der Schaltleiste 310, wenn sich der Abstand D zwischen den Elektroden 320, 330 verändert. Diese Änderung der Kapazität kann von einer geeigneten elektronischen Schaltung, wie einer weiter unten beschriebenen Steuereinheit, erfasst werden und ein Schaltereignis darstellen.

Ist die Kraft F groß genug, wird sich die Schaltleiste 310 so weit verformen, dass die beiden Elektroden 320, 330 an den inneren Kontaktflächen 323, 333 miteinander in Kontakt kommen. Dieser Kurzschluss kann ebenfalls ein Schaltereignis darstellen.

Das zehnte Ausführungsbeispiel einer Schaltleiste 310 ist ähnlich zu dem achten Ausführungsbeispiel und wird daher nur in seinen Unterschieden beschrieben.

Bei der Schaltleiste 310 gemäß dem neunten Ausführungsbeispiel ist der Sensorabschnitt 363 aus einem mit einem leitfähigem Zusatz, wie Graphit, versehenem EPDM gebildet.

Eine beispielhafte Sicherheitssensorleiste 100 entsprechend der vorliegenden Erfindung umfasst ein Trägerprofil 110 und eine Schaltleiste 10 entsprechend der vorliegenden Erfindung. Das Trägerprofil 110 umfasst einen Befestigungsabschnitt 111 und einen Aufnahmeabschnitt 112. Der Befestigungsabschnitt 111 dient der Befestigung der Sicherheitssensorleiste 100 an einem zu überwachenden Bereich. Der Aufnahmeabschnitt 112 nimmt die Schaltleiste 10 auf. Der Befestigungsabschnitt 111 ist zusätzlich mit einer Klebstoffschicht 113 und einer Dichtmasse 114 versehen, um die Sicherheitssensorleiste 100 zuverlässig an einem Vorsprung oder Flansch zu befestigen. Die Dichtmasse 114 schützt den Vorsprung oder

Flansch vor Feuchtigkeit und Verschmutzung. Zusätzlich erhöht die Dichtmasse 114 die Dichtwirkung des Trägerprofils 110.

Der Aufnahmeabschnitt 112 ist als Hohlraum 120 ausgebildet, in den die Schaltleiste 10 eingezogen wird. Um das Einziehen der Schaltleiste 10 zu erleichtern, ist der Hohlraum 120 mit einer Gleitschicht 121 aus thermoplastischem Vulkanisat versehen. Die Schaltleiste 10 kann sich beim Einziehen verdrehen, was jedoch aufgrund der Radialsymmetrie der Schaltleiste 10 nicht relevant ist. Die Sicherheitssensorleiste 100 ist somit leichter und günstiger herstellbar.

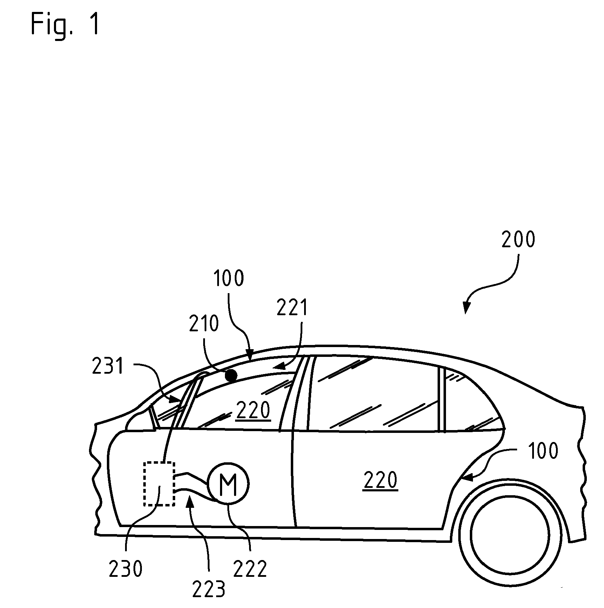

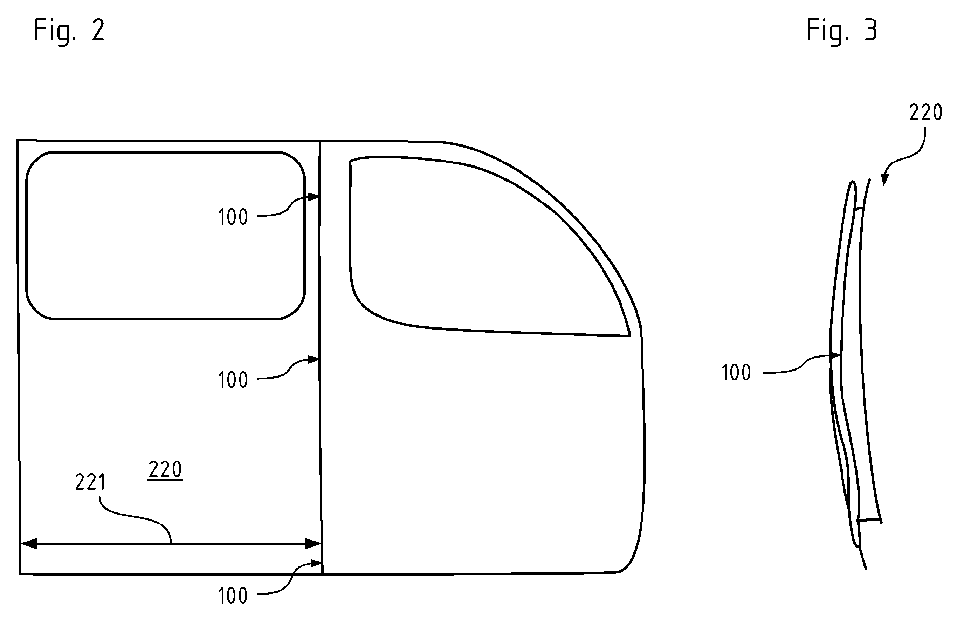

Die Sicherheitssensorleiste 100 kommt beispielsweise bei einer Schiebetür, wie sie in Fig. 2 und Fig. 3 schematisch gezeigt ist, zum Einsatz. Die Schiebetür stellt in diesem Fall ein Verschließelement 220 mit einem Bewegungsbereich 221 dar. Die Sicherheitssensorleiste 100 ist an einer Türkante angeordnet. Wie in Fig. 3 zu sehen, folgt die Sicherheitssensorleiste 100 dabei der Türkrümmung. Die Sicherheitssensorleiste 100 kommt bei einer Vorrichtung zum Erkennen eines Hindernisses 210 wie in Fig. 1 gezeigt zum Einsatz. Eine solche Vorrichtung wird auch als Einklemmschutz bezeichnet.

Ein Kraftfahrzeug 200 ist mit einem Einklemmschutz ausgestattet. Der Einklemmschutz umfasst eine Sicherheitssensorleiste 100, ein Verschließelement 220 und eine Steuereinheit 230. Das Verschließelement 220 hat einen Bewegungsbereich 221, in dem es sich zwischen einer Offen- und einer Schließstellung bewegt. Das Verschließelement 220 wird zum Öffnen oder zum Schließen von einem Motor 222 angetrieben. Der Motor 222 ist mittels einer Antriebsleitung 223 mit der Steuereinheit 230 verbunden. Die Steuereinheit 230 umfasst eine Sensorleitung 231, die mit der Sicherheitssensorleiste 100 verbunden ist.

Wird das Verschließelement 220 geschlossen und es befindet sich ein Hindernis 210 in dem Bewegungsbereich 221, wird die Sicherheitssensorleiste 100 von dem Hindernis verformt. Die Verformung der Sicherheitssensorleiste 100 führt zu einem Schaltereignis der Schaltleiste 10, das über die Sensorleitung 231 an die Steuereinheit 230 geleitet wird. Die Steuereinheit 230 schaltet zunächst den Motor 222 ab und lässt den Motor 222 dann ein kleines Stück zurückfahren. Dadurch wird die Verklemmung des Hindernisses 210 gelöst, und es kann entfernt werden.

Ein Herstellungsverfahren einer Sicherheitssensorleiste 100 umfasst das Bereitstellen einer Schaltleiste 10, die einen Mantel 60 aufweist, und eines Trägerprofils 110, das einen Aufnahmeabschnitt 112 und einen Befestigungsabschnitt 111 aufweist. Der Aufnahmeabschnitt 112 umfasst einen Hohlraum 120 und der Befestigungsabschnitt 111 ist eben ausgebildet.

Der Mantel 60 wird mit einer Gleitschicht 61 versehen. Ein Ende der Schaltleiste 10 wird an einem Ende des Trägerprofils 110 angeordnet und von einem Zugmittel ergriffen, das von dem anderen Ende des Trägerprofils 110 her durch den Hohlraum 120 verläuft. Das Zugmittel wird unter Drehen solange gezogen, bis eine gewünschte Länge des Trägerprofils mit der Schaltleiste 10 versehen ist. Dabei überträgt sich die Drehung des Zugmittels auf die Schaltleiste 10, die somit kontrolliert entlang der Längsrichtung verdrillt wird. Der Befestigungsabschnitt wird mit einer Klebstoffschicht 113 versehen.

Die Schaltleiste 10 kann ein Schaltereignis kapazitiv oder taktil unabhängig von der Richtung der angreifenden Kraft F erzeugen. Daher muss beim Einziehen der Schaltleiste 10 in das Trägerprofil 110 nicht auf die Ausrichtung der Schaltleiste 10 geachtet werden. Die Gleitschicht 61, 121 erleichtert das Einziehen. Die Sicherheitssensorleiste 100, die das Trägerprofil 110 und die Schaltleiste 10 umfasst, kann einfacher und kostengünstiger hergestellt werden. Der Einklemmschutz kann bei Kraftfahrzeugen bei Fenstern, Sonnendächern oder Türen, und auch beispielsweise bei Garagentoren verwendet werden.

### Bezugszeichenliste

- 10: Schaltleiste

- 20: Innenelektrode
- 21: Innendraht
- 22: Vorsprung

- 30: Außenelektrode
- 31: Außendraht
- 32: Vorsprung

- 40: Zwischenraum

- 50: Abstandhalter
- 51: Seitenfläche
- 52: Schwächungszone
- 53: Aussparung

- 60: Mantel
- 61: Gleitschicht
- 62: Klebesockel
- 63: Klebeband
- 64: Einknüpfsockel
- 65: Klemmsockel
- 66: Klemmlippe

- 100: Sicherheitssensorleiste
- 110: Trägerprofil
- 111: Befestigungsabschnitt
- 112: Aufnahmeabschnitt
- 113: Klebstoffschicht
- 114: Dichtmasse

- 120: Hohlraum
- 121: Gleitschicht

- 200: Kraftfahrzeug
- 210: Vorrichtung zum Erkennen eines Hindernisses
- 220: Verschließelement
- 221: Bewegungsbereich
- 222: Motor
- 223: Antriebsleitung

- 230: Steuereinheit
- 231: Sensorleitung

- 310: Schaltleiste

- 320: Grundelektrode
- 321: Grunddraht
- 322: Vorsprung
- 323: konkave innere Kontaktfläche
- 324: erste konvexe äußere Kontaktfläche

- 330: Sensorelektrode
- 331: Sensordraht
- 333: konvexe innere Kontaktfläche
- 334: zweite konvexe äußere Kontaktfläche

- 340: Zwischenraum

- 360: Mantel
- 361: Gleitschicht
- 362: Grundabschnitt
- 363: Sensorabschnitt

- D: Abstand
- F: Kraft

## Patentansprüche

1. Schaltleiste (10) für eine Vorrichtung zum Erkennen eines Hindernisses (210) in dem Bewegungsbereich (221) eines Verschließelements (220), insbesondere eines Kraftfahrzeugs (200), wobei die Schaltleiste (10) sich in eine Längsrichtung erstreckt und eine Kapazität aufweist, umfassend:
eine Innenelektrode (20), die mit einer ersten elektrischen Ladung belegbar ist;
eine durch eine von außen angelegte Kraft (F) verformbare Außenelektrode (30), die mit einer zweiten elektrischen Ladung belegbar ist und die in einem quer zu der Längsrichtung verlaufenden Schnitt annähernd kreisringförmig ausgebildet ist und die Innenelektrode (20) in einem Abstand (D) annähernd konzentrisch umgibt;
einen mit Luft gefüllten Zwischenraum (40), der zwischen der Außenelektrode (30) und der Innenelektrode (20) angeordnet und dielektrisch ist, und
wobei bei einer Verformung der Außenelektrode (30) die Verformung geeignet ist, die Innenelektrode (20) und die Außenelektrode (30) wenigstens abschnittsweise miteinander in Kontakt zu bringen, **gekennzeichnet durch** wenigstens einen im Querschnitt gekrümmt ausgebildeten Abstandhalter (50), der zwei in dieselbe Umfangsrichtung der Schaltleiste (10) gekrümmte Seitenflächen (51) aufweist und der quer zu der Längsrichtung verformbar ist und der die Innenelektrode (20) und die Außenelektrode (30) voneinander beabstandet und isoliert.

2. Schaltleiste (10) nach Anspruch 1, **gekennzeichnet durch** wenigstens einen weiteren Abstandhalter (50), wobei die Abstandhalter (50) in Umfangsrichtung der Elektroden (20, 30) äquidistant angeordnet sind.

3. Schaltleiste (10) nach Anspruch 1 oder 2, **dadurch gekennzeichnet, dass** der Abstandhalter (50) einen annähernd rechteckigen Querschnitt aufweist.

4. Schaltleiste (10) nach einem der Ansprüche 1 bis 3, **dadurch gekennzeichnet, dass** der Abstandhalter (50) eine Schwächungszone (52) aufweist.

5. Schaltleiste (10) nach Anspruch 4, **dadurch gekennzeichnet, dass** die Schwächungszone (52) als Aussparung (53) in dem Abstandhalter oder durch einen Elastomerbereich, der eine niedrigere Härte im Vergleich zu dem angrenzenden Elastomerbereich aufweist, gebildet ist.

6. Schaltleiste (10) nach einem der Ansprüche 1 bis 5, **dadurch gekennzeichnet, dass** die Außenelektrode (30) wenigstens drei Vorsprünge (22) umfasst, wobei die Vorsprünge (22) in Umfangsrichtung äquidistant voneinander beabstandet sind.

7. Schaltleiste (10) nach einem der Ansprüche 1 bis 6, **gekennzeichnet durch** einen Außendraht (31), der in die Außenelektrode (30) eingebettet ist, und/oder einen Innendraht (21), der in die Innenelektrode (20) eingebettet ist.

8. Schaltleiste (10) nach einem der Ansprüche 1 bis 7, **dadurch gekennzeichnet, dass** die Außenelektrode (30) und/oder die Innenelektrode (20) wenigstens teilweise aus einem mit elektrisch leitfähigen Partikeln versehenen Elastomer gefertigt, insbesondere extrudiert, ist.

9. Schaltleiste (10) nach einem der Ansprüche 1 bis 8, **gekennzeichnet durch** einen Mantel (60), wobei der Mantel (60) an die Außenelektrode (30) angrenzt.

10. Schaltleiste (10) nach Anspruch 9, **dadurch gekennzeichnet, dass** der Mantel (60) eine Gleitschicht (61), insbesondere aus Lack, thermoplastischem Vulkanisat und/oder Folie, aufweist.

11. Schaltleiste (10) nach einem der Ansprüche 1 bis 10, **dadurch gekennzeichnet, dass** der Mantel (60) und/oder der Abstandhalter (50) aus einem Elastomer, insbesondere einem Ethylen-Propylen-Dien-Kautschuk oder einem thermoplastischen Elastomer, gefertigt, insbesondere extrudiert, ist.

12. Sicherheitssensorleiste (100), umfassend:
ein Trägerprofil (110), das einen Befestigungsabschnitt (111) und einen Aufnahmeabschnitt (112) aufweist, und
eine Schaltleiste (10) nach einem der Ansprüche 1 bis 11, die in dem Aufnahmeabschnitt (112) angeordnet ist.

13. Sicherheitssensorleiste (100) nach Anspruch 12, **dadurch gekennzeichnet, dass** der Aufnahmeabschnitt (112) einen Hohlraum (120) umfasst und die Schaltleiste (10) in dem Hohlraum (120) angeordnet ist.

14. Vorrichtung zum Erkennen eines Hindernisses (210) in dem Bewegungsbereich (221) eines Verschließelements (220), insbesondere eines Kraftfahrzeugs (200), umfassend:
wenigstens eine Sicherheitssensorleiste (100) nach einem der Ansprüche 12 oder 13, und
eine Steuereinheit (230), die einen Öffnungs- oder Schließvorgang des Verschließelements (220) in Abhängigkeit von der Sicherheitssensorleiste (100) steuert.

15. Verfahren zur Herstellung einer Sicherheitssensorleiste (100) nach Anspruch 13, umfassend die Schritte:
a) Bereitstellen des Trägerprofils (110);
b) Bereitstellen der Schaltleiste (10) nach einem der Ansprüche 1 bis 11, und
c) Einziehen der Schaltleiste (10) in den Hohlraum (120) unter Drehen und/oder unter Beaufschlagen eines Grenzvolumens zwischen der Außenfläche der Schaltleiste (10) und der Innenfläche des Aufnahmeabschnitts (112) mit Druckluft.

## Claims

1. A switch strip (10) for an apparatus for detecting an obstruction (210) in the movement range (221) of a closure element (220), in particular of an automotive vehicle (200), wherein the switch strip (10) extends in a longitudinal direction and has a capacity, comprising:
an inner electrode (20), to which a first electric charge is applicable;
an outer electrode (30), which is deformable by a force (F) applied from the outside, to which a second electric charge is applicable and which is formed to be approximately circular in a section extending transverse to the longitudinal direction and approximately concentrically surrounds the inner electrode (20) at a distance (D);
a space (40) filled with air, which is arranged between the outer electrode (30) and the inner electrode (20) and which is dielectric, and
wherein, when the outer electrode (30) is deformed, the deformation is able to at least in portions bring the inner electrode (20) and the outer electrode (30) into contact with each other, **characterized by**
at least one spacer (50), which has a curved configuration in cross-section, which has two curved side surfaces (51), which are curved in the same circumferential direction as the switch strip (10), and is deformable in a direction transverse to the longitudinal direction and which spaces and insulates the inner electrode (20) from the outer electrode (30).

2. The switch strip (10) according to claim 1, **characterized by** at least one further spacer (50), wherein the spacers (50) are equidistantly arranged in the circumferential direction of the electrodes (20, 30).

3. The switch strip (10) according to claim 1 or 2, **characterized in that** the spacer (50) has an approximately rectangular cross-section.

4. The switch strip (10) according to any of claims 1 to 3, **characterized in that** the spacer (50) has a weakening zone (52).

5. The switch strip (10) according to claim 4, **characterized in that** the weakening zone (52) is formed as a recess (53) in the spacer or by an elastomeric region having reduced hardness in comparison to the adjacent elastomeric region.

6. The switch strip (10) according to any of claims 1 to 5, **characterized in that** the outer electrode (30) comprises at least three protrusions (22), wherein the protrusions (22) are equidistantly spaced from each other in the circumferential direction.

7. The switch strip (10) according to any of claims 1 to 6, **characterized by** an outer wire (31) embedded in the outer electrode (30) and/or an inner wire (21) embedded in the inner electrode (20).

8. The switch strip (10) according to any of claims 1 to 7, **characterized in that** the outer electrode (30) and/or the inner electrode (20) are at least partially made, in particular extruded, of an elastomer provided with electrically conductive particles.

9. The switch strip (10) according to any of claims 1 to 8, **characterized by** a sheath (60), wherein the sheath (60) is adjacent to the outer electrode (30).

10. The switch strip (10) according to claim 9, **characterized in that** the sheath (60) includes a sliding layer (61), in particular of a paint, a thermoplastic vulcanizate and/or a foil.

11. The switch strip (10) according to any of claims 1 to 10, **characterized in that** the sheath (60) and/or the spacer (50) are made, in particular extruded, of an elastomer, in particular of an ethylene propylene diene rubber or a thermoplastic elastomer.

12. A safety sensor strip (100), comprising:
a carrier profile (110) including an attachment portion (111) and a receiving portion (112), and
a switch strip (10) according to any of claims 1 to 11, which is arranged in the receiving portion (112).

13. The safety sensor strip (100) according to claim 12, **characterized in that** the receiving portion (112) comprises a cavity (120) and the switch strip (10) is arranged in the cavity (120).

14. An apparatus for detecting an obstruction (210) in the movement range (221) of a closure element (220), in particular of an automotive vehicle (200), comprising:
at least one safety sensor strip (100) according to any of claims 12 or 13, and
a control unit (230), which controls an opening and closing operation of the closure element (220) in dependence on the safety sensor strip (100).

15. A method of manufacturing a safety sensor strip (100) according to claim 13 comprising the steps of:
a) providing the carrier profile (110);
b) providing the switch strip (10) according to any of claims 1 to 11, and
c) threading the switch strip (10) into the cavity (120) while rotating the switch strip (10) and/or applying pressurized air to a boundary volume between the outer surface of the switch strip (10) and the inner surface of the receiving portion (112).

## Revendications

1. Bordure sensitive (10) pour un dispositif destiné à reconnaître un obstacle (210) dans la zone de mouvement (221) d'un élément de fermeture (220), en particulier d'un véhicule automobile (200), la bordure sensitive (10) s'étendant dans une direction longitudinale et présentant une capacité, incluant :
une électrode intérieure (20) qui est susceptible d'être chargée d'une première charge électrique ;
une électrode extérieure (30) déformable par une force (F) appliquée de l'extérieur, qui est susceptible d'être chargée par une seconde charge électrique et qui, en coupe transversale à la direction longitudinale, est réalisée approximativement en forme circulaire et entoure approximativement concentriquement l'électrode intérieure (20) à une distance (D),
un intervalle (40) rempli d'air, qui est disposé entre l'électrode extérieure (30) et l'électrode intérieure (20) et qui est diélectrique, et
dans laquelle, lors d'une déformation de l'électrode extérieure (30), la déformation est apte à mettre en contact l'électrode intérieure (20) et l'électrode extérieure (30) au moins partiellement l'une avec l'autre,
**caractérisée par**
au moins un écarteur (50) de section transversale recourbée qui présente deux surfaces latérales (51) recourbées dans la même direction périphérique de la bordure sensitive (10) et qui est déformable transversalement à la direction longitudinale et qui écarte et isole l'électrode intérieure (20) et l'électrode extérieure (30) l'une de l'autre.

2. Bordure sensitive (10) selon la revendication 1, **caractérisée par** au moins un autre écarteur (50), les écarteurs (50) étant agencés de façon équidistante en direction périphérique des électrodes (20, 30).

3. Bordure sensitive (10) selon la revendication 1 ou 2, **caractérisée en ce que** l'écarteur (50) présente une section transversale approximativement rectangulaire.

4. Bordure sensitive (10) selon l'une des revendications 1 à 3, **caractérisée en ce que** l'écarteur (50) présente une zone d'affaiblissement (52).

5. Bordure sensitive (10) selon la revendication 4, **caractérisée en ce que** la zone d'affaiblissement (52) est réalisée sous forme d'échancrure (53) dans l'écarteur ou par une zone élastomère qui présente une dureté inférieure par comparaison à la zone élastomère adjacente.

6. Bordure sensitive (10) selon l'une des revendications 1 à 5, **caractérisée en ce que** l'électrode extérieure (30) comprend au moins trois saillies (22), les saillies (22) étant écartées de façon équidistante les unes des autres en direction périphérique.

7. Bordure sensitive (10) selon l'une des revendications 1 à 6, **caractérisée par** un fil extérieur (31) qui est noyé dans l'électrode extérieure (30) et/ou un fil intérieur (21) qui est noyé dans l'électrode intérieure (20).

8. Bordure sensitive (10) selon l'une des revendications 1 à 7, **caractérisée en ce que** l'électrode extérieure (30) et/ou l'électrode intérieure (20) est fabriquée, en particulier extrudée, au moins partiellement en élastomère pourvu de particules électriquement conductrices.

9. Bordure sensitive (10) selon l'une des revendications 1 à 8, **caractérisée par** une enveloppe (60), l'enveloppe (60) étant adjacente à l'électrode extérieure (30).

10. Bordure sensitive (10) selon la revendication 9, **caractérisée en ce que** l'enveloppe (60) présente une couche de glissement (61), en particulier en laque, en matériau vulcanisé thermoplastique et/ou en film.

11. Bordure sensitive (10) selon l'une des revendications 1 à 10, **caractérisée en ce que** l'enveloppe (60) et/ou l'écarteur (50) est fabriqué(e), en particulier extrudé(e), en un élastomère, en particulier en caoutchouc éthylène-propylène-diène ou en un élastomère thermoplastique.

12. Bordure de détection de sécurité (100), incluant :
un profilé porteur (110) qui comprend un tronçon de fixation (111) et un tronçon de réception (112), et
une bordure sensitive (10) selon l'une des revendications 1 à 11, qui est agencée dans le tronçon de réception (112).

13. Bordure de détection de sécurité (100) selon la revendication 12, **caractérisée en ce que** le tronçon de réception (112) comprend un cavité (120) et la bordure sensitive (10) est agencée dans la cavité (120).

14. Dispositif pour reconnaître un obstacle (210) dans la zone de mouvement (221) d'un élément de fermeture (220), en particulier d'un véhicule automobile (200), incluant :
au moins une bordure de détection de sécurité (100) selon l'une des revendications 12 ou 13, et
une unité de commande (230) qui commande une opération d'ouverture ou de fermeture de l'élément de fermeture (220) en fonction de la bordure de détection de sécurité (100).

15. Procédé de fabrication d'une bordure de détection de sécurité (100) selon la revendication 13, incluant les étapes suivantes :
a) on met à disposition le profilé porteur (110) ;
b) on met à disposition la bordure sensitive (10) selon l'une des revendications 1 à 11, et
c) on insère la bordure sensitive (10) dans la cavité (120) en faisant tourner et/ou en sollicitant par de l'air comprimé un volume limite entre la surface extérieure de la bordure sensitive (10) et la surface intérieure du tronçon de logement (112).
